# EUROPEAN PATENT APPLICATION

(11) **EP 2 048 920 A2**
(43) Date of publication of application: **15.04.2009**
(21) Application number: 08164636.6
(22) Date of filing: 18.09.2008
(51) Int. Cl.: H05K 1/02, H05K 1/18

(54) **Power electronic module having improved heat dissipation capability**

(30) Priority: 09.10.2007 US 973518
(71) Applicant: Delphi Technologies, Inc., Troy, Michigan 48007 (US)
(72) Inventor: Oman, Tood P., Greentown, IN 46936 (US); Gertiser, Kevin M., Kokomo, IN 46904 (US); Shearer, Ronald M., Kokomo, IN 46901 (US)
(74) Representative: Denton, Michael John

(57) **Abstract**

A power electronic module (10) includes heat generating power electronic devices (40-52) mounted on a circuit board (12) within a connector outline (34) circumscribing circuit board through-holes (26) for receiving pin terminals (22) of a connector assembly (18). The power electronic devices (40-52) are thermally and electrically coupled to the circuit board through-holes (26) and connector pin terminals (22) to dissipate heat generated by the power electronic devices (40-52).

## Description

### TECHNICAL FIELD

The present invention relates to a power electronic module including power electronic devices and a connector assembly, and more particularly to a circuit board layout configuration that utilizes the connector assembly and wiring harness to dissipate heat generated by the power electronic devices.

### BACKGROUND OF THE INVENTION

In a conventional power electronic module, electronic devices are generally distributed throughout the circuit board surface area except in regions that are dedicated to connectors that interface the devices to an external wiring harness. The overall size of the circuit board is dictated not only by the connectors and the size and number of electronic devices, but also by the thermal heat dissipation capability required to cool high current electronic devices such as power transistors and power diodes. What is needed is a way of improving the thermal heat dissipation capability of a power electronic module so that the circuit board and module size can be reduced to take advantage of component miniaturization.

### SUMMARY OF THE INVENTION

The present invention is directed to an improved power electronic module including heat generating power electronic devices mounted on a circuit board within a connector outline circumscribing circuit board through-holes in which the pin terminals of a connector assembly are received. The power electronic devices are soldered to conductor traces electrically and thermally coupled to the circuit board through-holes so that heat generated by the devices is more effectively dissipated through the connector pin terminals and associated wiring harness. The electronic devices are preferably leadless packages having large copper pads that are soldered to circuit board traces within the connector outline. This arrangement is particularly advantageous in connection with a multi-layer circuit board because device electrodes not tied to the pin terminals of the connector are routed away from the connector outline by buried conductor layers.

### BRIEF DESCRIPTION OF THE DRAWINGS

FIG. 1 is partial cross-sectional view of a power electronic module according to this invention, including a connector, a circuit board and power electronic devices.

FIG. 2 is an overhead view of the circuit board and power electronic devices of FIG. 1.

### DESCRIPTION OF THE PREFERRED EMBODIMENT

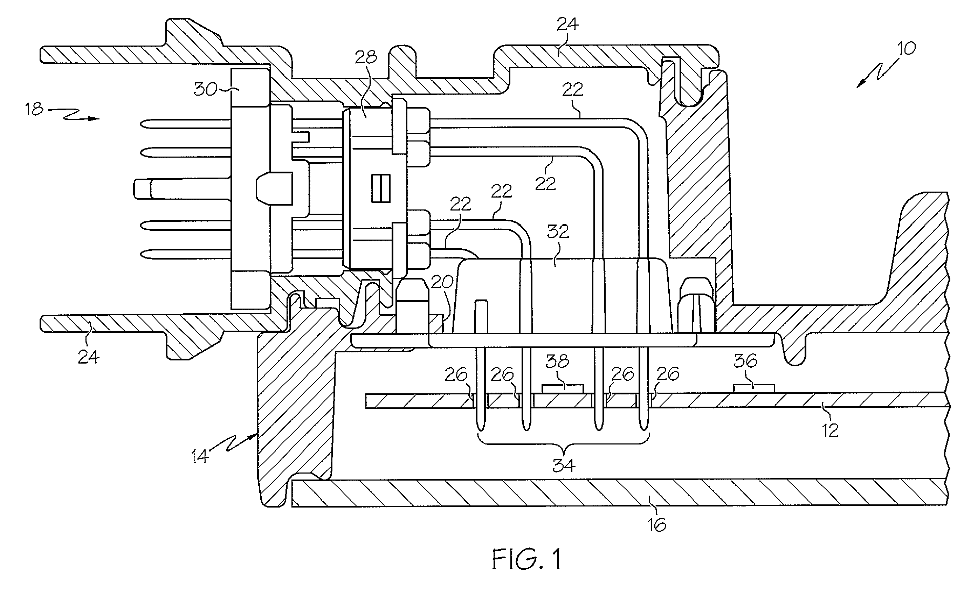

Referring to FIG. 1, the reference numeral 10 generally designates a power electronic module according to this invention. In general, module 10 includes a printed circuit board 12 supported within an open-ended metal housing 14, a cover plate 16 fastened to the open end of the housing 14, and a connector assembly 18 that interfaces with circuit board 12 through an opening 20 provided in the top of the housing 14. The illustrated connector assembly 18 is a horizontal-mount configuration with four rows of L-shaped pin terminals 22 that enter module 10 substantially parallel to the plane of circuit board 12, and then bend downward 90° to meet circuit board 12 at a right angle. The outboard ends of the pin terminals 22 are disposed within a plastic connector shroud 24, while the inboard ends of pin terminals 22 pass through plated through-holes formed 26 in circuit board 12. The pin terminals 22 are supported within connector shroud 24 by a pin block 28 and a pin blade stabilizer 30. And prior to entering circuit board 12, the pin terminals 22 pass through a pin alignment fixture 32 keyed to the housing 14 to ensure that the pin terminals 22 are properly aligned with the circuit board through-holes 26.

In conventional practice, electronic components, and particularly power devices such as power transistors and power diodes, are distributed over the face(s) of circuit board 12 except in the region 34 of the plated through-holes 26 for connector pin terminals 22. In FIG. 1, for example, the reference numeral 36 designates a power device located outside the region 34 according to conventional practice. In contrast, the present invention recognizes that power devices may be advantageously located within the region 34, as designated for example by the power device 38 in FIG. 1. Locating the power device 38 in the region 34 of circuit board 12 significantly enhances the thermal coupling between device 38 and the pin terminals 22 of connector assembly 18, allowing the pin terminals 22 and any external wiring harness (not shown) coupled to the connector assembly 18 to more effectively dissipate heat generated by the power device 38. The thermal coupling is particularly enhanced in the case of leadless power device packages having large copper pads that are soldered to circuit board traces 54 extending from the pin connectors 22. Examples of such power device packages include PQFN, QFN, SO-8, DCA and DPAK.

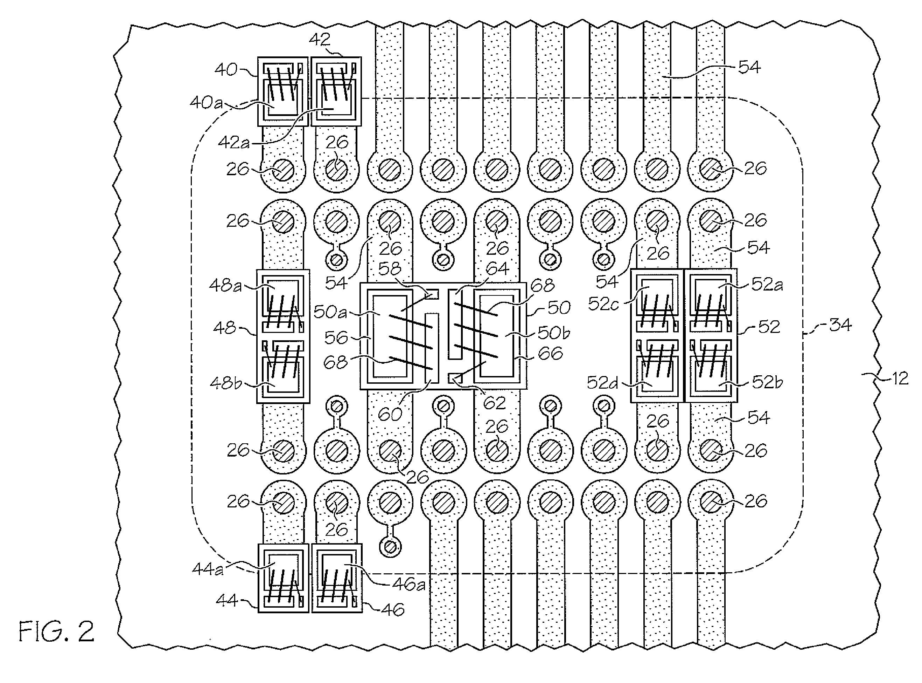

FIG. 2 shows the connector region 34 as an outline circumscribing an array of through-holes 26, with the pin terminals 22 removed for ease of illustration, and illustrates several leadless power device packages 40-52 disposed at least partially within the region 34. The plated through-holes 26 are each coupled to copper conductor traces 54 formed on the face of circuit board 12, and the device packages 40-52 are soldered to respective conductor traces 54. The packages 40-46 are disposed outboard of the plated through-holes 26, while the packages 48-52 are disposed in a space between adjacent rows of plated through-holes 26. But in each case, the soldered connections between the device packages and the circuit board traces 54 electrically and thermally couple the device packages 40-52 to respective through-holes 26, to pin terminals 22 inserted in the through-holes 26, and to any wiring harness (not shown) coupled to the pin terminals 22.

In the illustration of FIG. 2, the power device packages 40-52 all contain power transistors such as FETs or IGBTs, although it will be appreciated that other power devices such as power diodes may be used as well or instead. The packages 40, 42, 44 and 46 each house a single transistor die 40a, 42a, 44a and 46a; the packages 48 and 50 each house two transistor die 48a, 48b and 50a, 50b; and the package 52 houses four transistor die 52a, 52b, 52c, 52d.

As specifically illustrated in respect to package 50, each of the power device packages 40-52 contains a set of solderable copper leadframe pads 56, 58, 60, 60, 64, 66, one or more semiconductor die 50a, 50b, and a set of wirebonds 68, all overmolded with a plastic encapsulant, although the encapsulant covering the copper pads 56-66, die 50a-50b and wirebonds 68 has been removed for purposes of illustration. The exposed bottom-side of each copper leadframe pad 56-66 is soldered to a respective conductor trace 54 of circuit board 12, and the semiconductor die 50a and 50b are soldered to the top-sides of the copper pads 56 and 66 before over-molding. Wirebonds 68 electrically couple the top-side terminals of die 50a and 50b to the copper pads 58-64. For example, the die 50a can be an IGBT having a bottom-side collector electrode soldered to the copper pad 56, a top-side emitter electrode wire-bonded to the copper pad 60, and a top-side gate electrode wire-bonded to the copper pad 58; where the copper pads 56, 58 and 60 are each soldered to a corresponding copper circuit board trace 54. The trace 54 soldered to copper pad 56 (i.e., the IGBT collector) is electrically and thermally coupled to one or more (two in this case) plated through-holes 26 of circuit board 12, while the traces (not shown) soldered to copper pads 58-64 are electrically coupled to buried conductor traces of circuit board 12.

In summary, the present invention provides a practical and cost-effective way of increasing the thermal heat dissipation capability of a power electronic module by more effectively utilizing the thermal heat capacity of connector and wiring harness components. In modules where reductions in the circuit board size are limited by heat dissipation requirements, locating leadless power electronic devices to utilize the thermal heat capacity of connector and wiring harness components as described herein allows the circuit board and module size to be reduced for a given set of power electronic devices, or alternately, allows the circuit power dissipation to be increased without having to correspondingly increase the circuit board and module size.

While the method has been described with respect to the illustrated embodiment, it is recognized that numerous modifications and variations in addition to those mentioned herein will occur to those skilled in the art. For example, the number of connectors and pin terminals, and the type and number of electronic devices, may be different than shown, the pin terminals 22 and through-holes 26 may be arranged in a circular or other pattern, the connector assembly 18 may be a vertical-mount connector design, and so forth. Furthermore, a similar arrangement of electronic devices can also be mounted on the underside of circuit board 12. Accordingly, it is intended that the invention not be limited to the disclosed embodiment, but have the full scope permitted by the language of the following claims.

## Claims

1. A power electronic module (10), comprising:
a printed circuit board (12) having an array of through-holes (26) within a connector region (34) of said circuit board (12), and conductor traces (54) electrically and thermally coupled to said through-holes (26);
a connector assembly (18) having an array of pin terminals (22) electrically and thermally coupled to said through-holes (26); and
a heat generating power electronic package (50) having at least one conductive pad (56) that is soldered to at least one of said conductor traces (54) within said connector region (34) so that heat generated by said power electronic package (50) is thermally coupled to said conductor trace (54), a respective through-hole (26) and a respective pin terminal (22) of said connector assembly (18).

2. The power electronic module of claim 1, where:
said array of through-holes (26) and said array of pin terminals (22) are arranged in parallel rows, and the conductive pad (56) of said heat generating power electronic package (50) is soldered to a conductor trace (54) disposed between the rows of through-holes (26) and pin terminals (22).

3. The power electronic module of claim 1, where:
said array of through-holes (26) includes first and second through-holes, and the conductive pad (56) of said heat generating power electronic package (50) is soldered to a conductor trace (54) electrically and thermally coupling said first and second through-holes.

4. The power electronic module of claim 1, where:
said heat generating power electronic package (50) has multiple conductive pads (56, 66) that are individually soldered one or more of said conductor traces (54) within said connector region (34).

5. The power electronic module of claim 1, where:
said heat generating power electronic package (50) includes a semiconductor die (50a) having an electrode that is soldered to said at least one conductive pad (56).
